# EUROPEAN PATENT APPLICATION

(11) **EP 4 494 880 A1**
(43) Date of publication of application: **22.01.2025**
(21) Application number: 23770505.8
(22) Date of filing: 06.03.2023
(51) Int. Cl.: B41J 2/14

(54) **PIEZOELECTRIC ACTUATOR, LIQUID EJECTION HEAD, AND RECORDING DEVICE**

(30) Priority: 14.03.2022 JP 2022039088
(71) Applicant: Kyocera Corporation, Kyoto-shi, Kyoto 612-8501 (JP)
(72) Inventor: KAKU, Ryota, Kyoto-shi, Kyoto 612-8501 (JP); ARIKI, Kazuhiro, Kyoto-shi, Kyoto 612-8501 (JP); IKEUCHI, Wataru, Kyoto-shi, Kyoto 612-8501 (JP); HOZUMI, Daisuke, Kyoto-shi, Kyoto 612-8501 (JP)
(74) Representative: Viering, Jentschura & Partner mbB Patent- und Rechtsanwälte
(86) International application number: PCT/JP2023/008323
(87) International publication number: WO 2023/176549

(57) **Abstract**

A piezoelectric actuator according to the present disclosure of the present disclosure includes a piezoelectric element that is deformed by application of a voltage. The piezoelectric element includes a vibrating plate, an internal electrode, a piezoelectric ceramic body, a surface electrode, a connection electrode, and a groove portion. The internal electrode is located on a surface of the vibrating plate. The piezoelectric ceramic body is located on a surface of the internal electrode. The surface electrode is located on a surface of the piezoelectric ceramic body. The connection electrode is located on the surface of the piezoelectric ceramic body and connected to the surface electrode. In a plan view of the piezoelectric element as viewed from a direction perpendicular to the surface of the piezoelectric ceramic body, the groove portion is located around or inside the surface electrode and extends in a shape corresponding to the outer shape of the surface electrode. The groove portion includes a deep groove portion and a shallow groove portion. The deep groove portion has a depth equal to or greater than a depth such that the deep groove portion reaches the internal electrode. The shallow groove portion is located closer to the connection electrode than the deep groove portion and has a depth less than a depth such that the shallow groove portion reaches the internal electrode.

## Description

### TECHNICAL FIELD

The disclosed embodiments relate to a piezoelectric actuator, a liquid discharge head and a recording device.

### BACKGROUND OF INVENTION

As a printing apparatus, an inkjet printer, an inkjet plotter, or the like using an inkjet recording method is known. A liquid discharge head for discharging a liquid is mounted in such a printing apparatus using an inkjet method.

The liquid discharge head discharges the liquid in a pressure chamber from a nozzle by changing a pressure in the pressure chamber by driving a piezoelectric element located above the pressure chamber. The piezoelectric element includes a piezoelectric body, an internal electrode located inside the piezoelectric body, and a surface electrode located on a surface of the piezoelectric body.

Patent Document 1 discloses a piezoelectric element in which a groove portion surrounding a surface electrode is formed around the surface electrode for the purpose of reducing the occurrence of crosstalk between piezoelectric elements. In the thickness direction of the piezoelectric element, the groove portion reaches a position deeper than a position of the internal electrode.

### CITATION LIST

### PATENT LITERATURE

Patent Document 1: JP 2003-311954 A

### SUMMARY

A piezoelectric actuator according to an aspect of an embodiment includes a piezoelectric element that is deformed by application of a voltage. The piezoelectric element includes a vibrating plate, an internal electrode, a piezoelectric ceramic body, a surface electrode, a connection electrode, and a groove portion. The internal electrode is located on a surface of the vibrating plate. The piezoelectric ceramic body is located on a surface of the internal electrode. The surface electrode is located on a surface of the piezoelectric ceramic body. The connection electrode is located on the surface of the piezoelectric ceramic body and connected to the surface electrode. In a plan view of the piezoelectric element as viewed from a direction perpendicular to the surface of the piezoelectric ceramic body, the groove portion is located around or inside the surface electrode and extends in a shape corresponding to the outer shape of the surface electrode. The groove portion includes a deep groove portion and a shallow groove portion. The deep groove portion has a depth equal to or greater than a depth such that the deep groove portion reaches the internal electrode. The shallow groove portion is located closer to the connection electrode than the deep groove portion and has a depth less than a depth such that the shallow groove portion reaches the internal electrode.

### BRIEF DESCRIPTION OF THE DRAWINGS

FIG. 1 is a schematic front view of a printer according to an embodiment.
FIG. 2 is a schematic plan view of the printer according to the embodiment.
FIG. 3 is a schematic exploded perspective view of a liquid discharge head according to the embodiment.
FIG. 4 is a schematic plan view illustrating a main portion of a head body according to the embodiment.
FIG. 5 is a schematic enlarged view of a region V illustrated in FIG. 4.
FIG. 6 is a schematic cross-sectional view taken along a line VI-VI of FIG. 5.
FIG. 7 is a schematic plan view of a piezoelectric element according to the embodiment.
FIG. 8 is a schematic cross-sectional view taken along a line VIII-VIII in FIG. 7.
FIG. 9 is a schematic view for explaining the position of a boundary portion between a deep groove portion and a shallow groove portion.
FIG. 10 is a schematic view illustrating an example of a position of the groove portion according to the embodiment.
FIG. 11 is a schematic view illustrating an example of the position of the groove portion according to the embodiment.
FIG. 12 is a schematic cross-sectional view of a groove portion according to a first alternative embodiment.
FIG. 13 is a schematic plan view illustrating a configuration of a groove portion according to a second alternative embodiment.
FIG. 14 is a schematic cross-sectional view illustrating the configuration of the groove portion according to the second alternative embodiment.
FIG. 15 is a schematic cross-sectional view illustrating a configuration of a groove portion according to a third alternative embodiment.
FIG. 16 is a schematic plan view illustrating a configuration of a piezoelectric element according to a fourth alternative embodiment.

### DESCRIPTION OF EMBODIMENTS

Hereinafter, embodiments of a piezoelectric actuator, a liquid discharge head, and a recording device disclosed in the present application will be described in detail with reference to the accompanying drawings. Note that the present invention is not limited by the following embodiments.

In the above-described conventional liquid discharge head, ion migration may occur. The ion migration is a phenomenon in which a metal on an anode side is ionized by application of a voltage, and the ionized metal moves to a cathode and is produced again as a metal at the cathode. When the metal produced at the cathode grows to reach the anode, the anode and the cathode may be electrically connected to each other to cause a short circuit.

Such a problem is not limited to the liquid discharge head, but is a problem common to a piezoelectric actuator having a piezoelectric element which is driven by application of a voltage, and a general device having such a piezoelectric actuator.

Therefore, provision of a piezoelectric actuator, a liquid discharge head, and a recording device capable of increasing the driving displacement of the piezoelectric element while suppressing the risk due to ion migration is expected.

### Printer Configuration

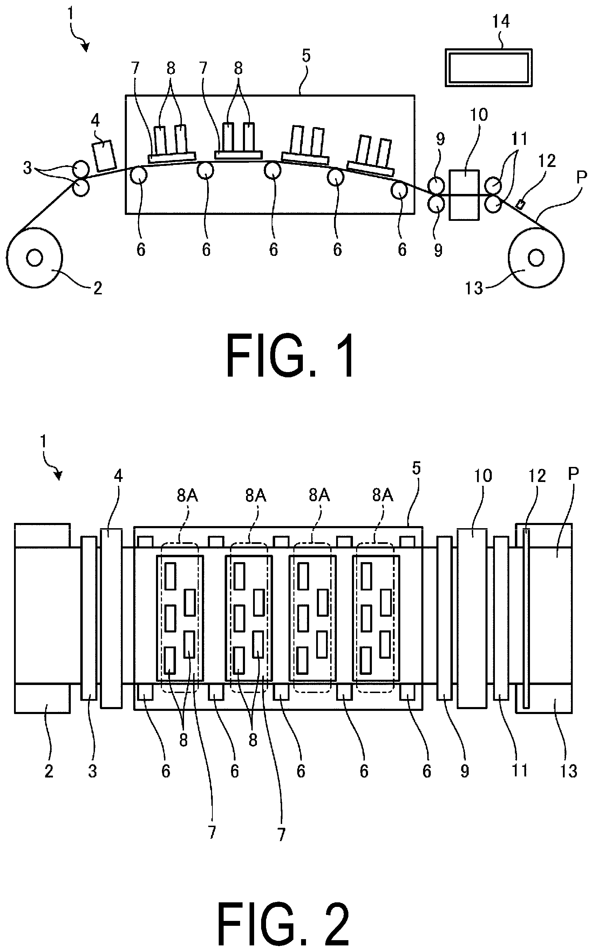

First, with reference to FIG. 1 and FIG. 2, a description will be given of an overview of a printer 1 serving as an example of a recording device according to an embodiment. FIG. 1 is a schematic front view of a printer 1 according to an embodiment. FIG. 2 is a schematic plan view of the printer 1 according to the embodiment. The printer 1 according to the embodiment is, for example, a color inkjet printer.

As illustrated in FIG. 1, the printer 1 includes a paper feed roller 2, guide rollers 3, an applicator 4, a head case 5, a plurality of transport rollers 6, a plurality of frames 7, a plurality of liquid discharge heads 8, a transport roller 9, a dryer 10, a transport roller 11, a sensor portion 12, and a collection roller 13. The transport roller 6 is an example of a transporter.

The printer 1 includes a controller 14 that controls each portion of the printer 1. The controller 14 controls the operation of the paper feed roller 2, the guide rollers 3, the applicator 4, the head case 5, the plurality of transport rollers 6, the plurality of frames 7, the plurality of liquid discharge heads 8, the transport rollers 9, the dryer 10, the transport rollers 11, the sensor portion 12, and the collection roller 13.

By landing droplets on a printing sheet P, the printer 1 records images or characters on the printing sheet P. The printing sheet P is an example of a recording medium. The printing sheet P is rolled on the paper feed roller 2 prior to use. The printer 1 transports the printing sheet P wound around the paper feed roller 2 into the head case 5 via the guide roller 3 and the applicator 4.

The applicator 4 uniformly applies a coating agent over the printing sheet P. This can perform surface treatment on the printing sheet P, improving the printing quality of the printer 1.

The head case 5 houses the plurality of transport rollers 6, the plurality of frames 7, and the plurality of liquid discharge heads 8. The inside of the head case 5 is formed with a space separated from the outside except for a part connected to the outside such as parts where the printing sheet P enters and exits.

As required, the controller 14 controls at least one of controllable factors of the internal space of the head case 5, such as temperature, humidity, and air pressure. The transport rollers 6 convey the printing sheet P near the liquid discharge heads 8 inside the head case 5.

The frames 7 are rectangular flat plates and are located above and close to the printing sheet P to be conveyed by the transport rollers 6. As illustrated in FIG. 2, the frames 7 are located having the longitudinal direction orthogonal to the conveyance direction of the printing sheet P. Inside the head case 5, the plurality of (e.g., 4) frames 7 is located at predetermined intervals along the conveyance direction of the printing sheet P.

A liquid, for example, ink, is supplied to the liquid discharge heads 8 from a liquid tank (not illustrated). The liquid discharge heads 8 discharge the liquid supplied from the liquid tank.

The controller 14 controls the liquid discharge heads 8 based on data of an image, characters, or the like to discharge the liquid toward the printing sheet P. The distance between each liquid discharge head 8 and the printing sheet P is, for example, approximately 0.5 mm to 20 mm.

Each of the liquid discharge heads 8 is fixed to the frame 7. The liquid discharge heads 8 are located having the longitudinal direction orthogonal to the conveyance direction of the printing sheet P.

That is, the printer 1 according to the embodiment is a so-called line printer in which the liquid discharge heads 8 are fixed inside the printer 1. Note that the printer 1 according to the embodiment is not limited to a line printer and may also be a so-called serial printer.

The serial printer is a printer employing a method of alternately performing operations of recording while moving the liquid discharge heads 8 in a manner such as reciprocation in a direction intersecting (e.g., substantially orthogonal to) the conveyance direction of the printing sheet P, and conveying the printing sheet P.

As illustrated in FIG. 2, a plurality of (e.g., five) liquid discharge heads 8 are fixed to one frame 7. FIG. 2 illustrates an example in which three liquid discharge heads 8 are located on the forward side and two liquid discharge heads 8 are located on the rear side, in the conveyance direction of the printing sheet P. Further, the liquid discharge heads 8 are located without their centers overlapping in the conveyance direction of the printing sheet P.

The plurality of liquid discharge heads 8 located in one frame 7 form a head group 8A. Four head groups 8A are located along the conveyance direction of the printing sheet P. The liquid discharge heads 8 belonging to the same head group 8A are supplied with ink of the same color. As a result, the printer 1 can perform printing with four colors of ink using the four head groups 8A.

The colors of the ink discharged from the respective head groups 8A are, for example, magenta (M), yellow (Y), cyan (C), and black (K). The controller 14 can print a color image on the printing sheet P by controlling the respective head groups 8A to discharge the plurality of colors of ink onto the printing sheet P.

Note that a surface treatment may be performed on the printing sheet P, by discharging a coating agent from the liquid discharge head 8 onto the printing sheet P.

The number of the liquid discharge heads 8 included in one head group 8A and the number of the head groups 8A mounted in the printer 1 can be changed as appropriate in accordance with printing targets or printing conditions, etc. For example, if the color to be printed on the printing sheet P is a single color and the range of the printing can be covered by a single liquid discharge head 8, only a single liquid discharge head 8 may be provided in the printer 1.

The printing sheet P printed inside the head case 5 is conveyed to the outside of the head case 5 by the transport rollers 9 and passes through the inside of the dryer 10. The dryer 10 dries the printing sheet P printed. The printing sheet P dried by the dryer 10 is transported by the transport rollers 11 and then collected by the collection roller 13.

In the printer 1, by drying the printing sheet P with the dryer 10, bonding, or rubbing of an undried liquid, between the printing sheets P overlapped with each other and rolled at the collection roller 13 can be reduced.

The sensor portion 12 includes a position sensor, a speed sensor, or a temperature sensor. Based on information from the sensor portion 12, the controller 14 can determine the state of each part of the printer 1 and control each part of the printer 1.

In the printer 1 described above, the printing sheet P is the printing target (i.e., the recording medium), but the printing target in the printer 1 is not limited to the printing sheet P, and a roll type fabric or the like may be the printing target.

The printer 1 may convey the printing sheet P put on a conveyor belt instead of directly conveying it. Using the conveyor belt allows the printer 1 to use a sheet of paper as a printing target, a cut cloth, wood, a tile, or the like to be printed.

The printer 1 may discharge a liquid containing electrically conductive particles from the liquid discharge heads 8, to print a wiring pattern or the like of an electronic device. The printer 1 may form chemicals by causing the liquid discharge head 8 to discharge a predetermined amount of a liquid chemical agent or a liquid containing a chemical agent toward a reaction vessel or the like.

### Configuration of Liquid Discharge Head

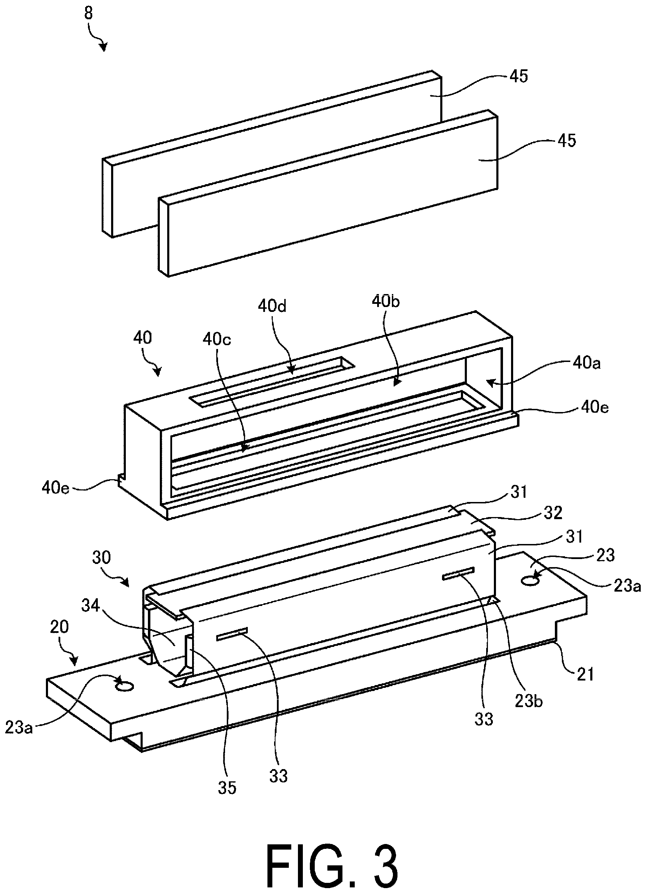

The configuration of the liquid discharge head 8 according to an embodiment will be described using FIG. 3. FIG. 3 is a schematic exploded perspective view of the liquid discharge head 8 according to the embodiment.

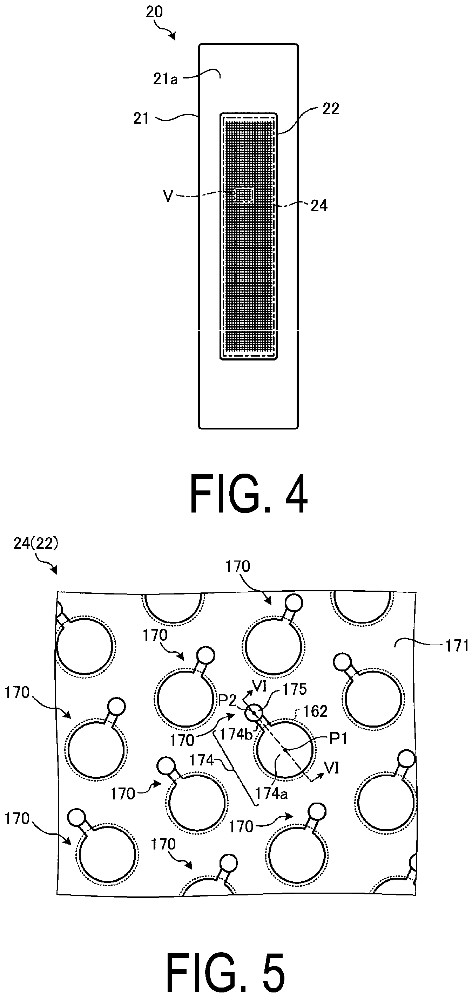

The liquid discharge head 8 includes a head body 20, a wiring portion 30, a housing 40, and a pair of heat dissipation plate 45. The head body 20 includes a channel member 21, a piezoelectric actuator 22 (see FIG. 4), and a reservoir 23.

In the following description, for convenience, the direction in which the head body 20 is provided in the liquid discharge head 8 may be represented as "lower", and the direction in which the housing 40 is provided with respect to the head body 20 may be represented as "upper".

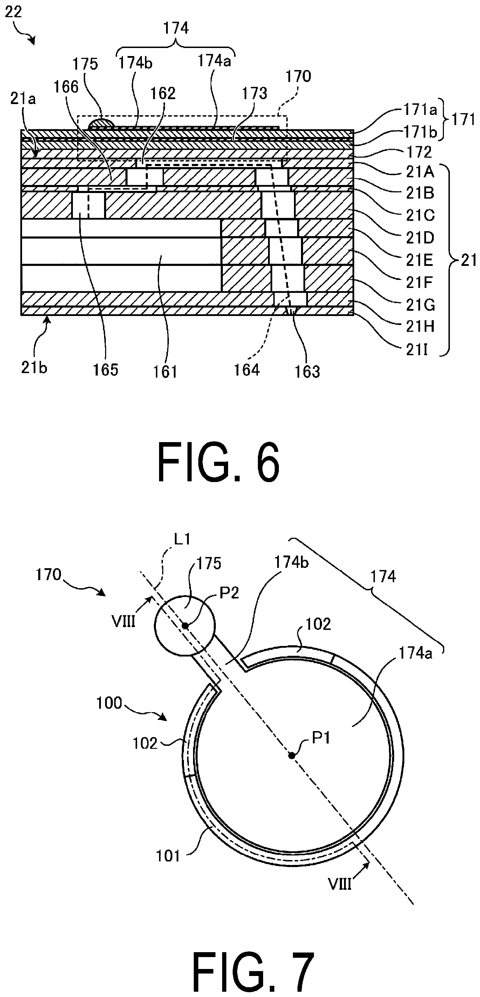

The channel member 21 of the head body 20 has a substantially flat plate shape, and includes a first surface 21a, which is one main surface, and the second surface 21b (see FIG. 6) located at an opposite side to the first surface 21a. The first surface 21a includes an opening not illustrated, and liquid is supplied from the reservoir 23 to the inside of the channel member 21 through the opening.

The second surface 21b has a plurality of discharge holes 163 (see FIG. 6) for discharging liquid onto the printing sheet P. The channel member 21 internally has a channel through which liquid flows from the first surface 21a to the second surface 21b.

The piezoelectric actuator 22 is located on the first surface 21a of the channel member 21. The piezoelectric actuator 22 includes a plurality of piezoelectric elements 170 (see FIG. 6). A flexible substrate 31 of the wiring portion 30 is electrically connected to the piezoelectric actuator 22.

The reservoir 23 is located on the piezoelectric actuator 22. The reservoir 23 is provided with openings 23a at both end portions in a main scanning direction, which is a direction orthogonal to a sub scanning direction, which is the conveyance direction of the printing sheet P, and parallel to the printing sheet P. The reservoir 23 includes a channel therein, and is supplied with a liquid from the outside through the opening 23a. The reservoir 23 supplies liquid to the channel member 21. The reservoir 23 stores liquid to be supplied to the channel member 21.

The wiring portion 30 includes the flexible substrate 31, a wiring board 32, a plurality of driver ICs 33, a pressing member 34, and an elastic member 35. The flexible substrate 31 transmits, to the head body 20, a predetermined signal sent from the outside. As illustrated in FIG. 3, the liquid discharge head 8 according to the embodiment may include two flexible substrates 31.

The flexible substrate 31 has one end portion electrically connected to the piezoelectric actuator 22 of the head body 20. The other end portion of the flexible substrate 31 is drawn upward in a manner to be inserted through a slit 23b of the reservoir 23, and is electrically connected to the wiring board 32. This enables the piezoelectric actuator 22 of the head body 20 and the outside to be electrically connected.

The wiring board 32 is located above the head body 20. The wiring board 32 distributes signals to the plurality of driver ICs 33.

The plurality of driver ICs 33 is located on a main surface of one of the flexible substrates 31. As illustrated in FIG. 3, in the liquid discharge head 8 according to an embodiment, two driver ICs 33 are provided on each flexible substrate 31, but the number of the driver ICs 33 provided on each flexible substrate 31 is not limited to two.

The driver IC 33 drives the piezoelectric actuator 22 of the head body 20 based on a drive signal sent from the controller 14 (see FIG. 1). With this configuration, the driver IC 33 drives the liquid discharge head 8.

The pressing member 34 has a substantially U shape in cross-sectional view, and presses the driver IC 33 on the flexible substrate 31 toward the heat dissipation plate 45 from the inside. As a result, in the embodiment, the heat generated when the driver IC 33 is driven can be efficiently radiated to the outer heat dissipation plate 45.

The elastic member 35 is disposed in a manner to be in contact with an outer wall of a pressing portion not illustrated in the pressing member 34. By providing such an elastic member 35, it is possible to reduce the likelihood of the pressing member 34 causing breakage of the flexible substrate 31 when the pressing member 34 presses the driver ICs 33.

The elastic member 35 is made of, for example, double-sided foam tape or the like. For example, by using a non-silicon-based thermal conductive sheet as the elastic member 35, it is possible to improve the heat radiating properties of the driver IC 33. Note that the elastic member 35 does not necessarily have to be provided.

The housing 40 is disposed on the head body 20 in a manner to cover the wiring portion 30. This enables the wiring portion 30 to be sealed with the housing 40. The housing 40 is made of, for example, resin or metal.

The housing 40 has a box shape elongated in the main scanning direction, and includes a first opening 40a and a second opening 40b at a pair of side surfaces opposed along the main scanning direction, respectively. The housing 40 includes a third opening 40c at a lower surface, and a fourth opening 40d at an upper surface.

One of the heat dissipation plates 45 is disposed in the first opening 40a to close the first opening 40a, and the other of the heat dissipation plate 45 is disposed in the second opening 40b to close the second opening 40b.

The heat dissipation plate 45 is provided to extend in the main scanning direction, and is made of metal, alloy, or the like having high heat radiating properties. The heat dissipation plate 45 is provided to be in contact with the driver IC 33, and radiates heat generated in the driver IC 33.

The pair of heat dissipation plates 45 is fixed to the housing 40 by screws not illustrated. Therefore, the housing 40 to which the heat dissipation plate 45 is fixed has a box shape in which the first opening 40a and the second opening 40b are closed and the third opening 40c and the fourth opening 40d are opened.

The third opening 40c is located to oppose the reservoir 23. The flexible substrate 31 and the pressing member 34 are inserted into the third opening 40c.

The fourth opening 40d is provided in order to insert a connector (not illustrated) provided on the wiring board 32. When a space between the connector and the fourth opening 40d is sealed with resin or the like, liquid, dust, or the like is less likely to enter the housing 40.

The housing 40 includes heat insulating portions 40e. The heat insulating portions 40e are respectively provided in a manner to be adjacent to the first opening 40a and the second opening 40b, and are provided in a manner to protrude outward from side surfaces of the housing 40 along the main scanning direction.

The heat insulating portions 40e are formed in a manner to extend in the main scanning direction. That is, the heat insulating portions 40e are located between the heat dissipation plates 45 and the head body 20. By providing the heat insulating portions 40e in the housing 40 as described above, heat generated by the driver IC 33 is less likely to be transferred to the head body 20 via the heat dissipation plates 45.

Note that FIG. 3 illustrates an example of the configuration of the liquid discharge head 8, which may further include a member other than the members illustrated in FIG. 3.

### Configuration of Head Body

A configuration of the head body 20 according to the embodiment will be described. FIG. 4 is a schematic plan view illustrating a main portion of the head body 20 according to the embodiment.

As described above, the head body 20 includes the channel member 21 and the piezoelectric actuator 22. The channel member 21 and the piezoelectric actuator 22 have a flat plate shape, and the piezoelectric actuator 22 is located at substantially the center of the channel member 21.

The piezoelectric actuator 22 has a discharge region 24. The plurality of piezoelectric elements 170 are located in the discharge region 24.

FIG. 5 is a schematic enlarged view of a region V illustrated in FIG. 4. FIG. 5 is a plan view of the piezoelectric element 170 as viewed from a direction perpendicular to the surface of the piezoelectric ceramic body 171. In FIG. 5, a groove portion 100 to be described below is omitted.

As illustrated in FIG. 5, the plurality of piezoelectric elements 170 are arranged at positions corresponding to a plurality of pressure chambers 162 included in the channel member 21. To be more specific, the plurality of piezoelectric elements 170 are arranged such that an electrode body 174a of the surface electrode 174 to be described below is located above the pressure chamber 162.

Here, a configuration of the channel member 21 including the pressure chamber 162 will be described. FIG. 6 is a schematic cross-sectional view taken along a line VI-VI in FIG. 5. The line VI-VI illustrated in FIG. 5 is a straight line passing through a center point P1 of the electrode body 174a of the surface electrode 174 described below and a center point P2 of the connection electrode 175 described below.

As illustrated in FIG. 6, the channel member 21 has a layered structure layering a plurality of plates. To be specific, the channel member 21 includes a cavity plate 21A, a base plate 21B, an aperture plate 21C, a supply plate 21D, manifold plates 21E, 21F, and 21G, a cover plate 21H, and a nozzle plate 211. These plates are located in this order from the first surface 21a side of the channel member 21. These plates are made of a metal such as stainless steel (SUS).

A large number of holes are formed in the plates constituting the channel member 21. The thickness of each plate is about 10 µm to 300 µm. This can increase the accuracy of forming the hole. The plates are layered in alignment such that these holes communicate with one another to constitute an individual channel 164 and a supply manifold 161.

In the channel member 21, the individual channel 164 connects between the supply manifold 161 and the discharge hole 163. The supply manifold 161 is located on the second surface 21b side inside the channel member 21, and the discharge hole 163 is located on the second surface 21b of the channel member 21.

The individual channel 164 includes a pressure chamber 162 and an individual supply channel 165. The pressure chamber 162 is located on the first surface 21a of the channel member 21, and the individual supply channel 165 is a channel which connects the supply manifold 161 and the pressure chamber 162.

The individual supply channel 165 includes an aperture 166 having a narrower width than other parts. Since the aperture 166 is narrower than the other parts of the individual supply channel 165, the channel resistance is high. As described above, when the channel resistance of the aperture 166 is high, the pressure generated in the pressure chamber 162 hardly escapes to the supply manifold 161.

Next, the configuration of the piezoelectric element 170 will be described with reference to FIGs. 5 and 6. As illustrated in FIGs. 5 and 6, the piezoelectric element 170 includes a piezoelectric ceramic body 171, a reinforcing plate 172, an internal electrode 173, a surface electrode 174, and a connection electrode 175.

The piezoelectric ceramic body 171 has a flat plate shape. The piezoelectric ceramic body 171 is located on the first surface 21a of the channel member 21 via the reinforcing plate 172.

The piezoelectric ceramic body 171 includes, for example, a plurality of piezoelectric ceramic layers 171a and 171b. Each of the piezoelectric ceramic layers 171a and 171b has, for example, a thickness of approximately 20 µm. Each of the piezoelectric ceramic layers 171a and 171b extends across the plurality of pressure chambers 162. The plurality of piezoelectric elements 170 share one piezoelectric ceramic body 171.

The piezoelectric ceramic layers 171a and 171b may be made of a ferroelectric lead-zirconate-titanate (PZT) ceramic material.

Here, an example in which the piezoelectric ceramic body 171 includes two piezoelectric ceramic layers 171a and 171b is illustrated, but the piezoelectric ceramic body 171 may include three or more piezoelectric ceramic layers.

The piezoelectric ceramic layer 171b is an example of a vibrating plate. The vibrating plate is not necessarily made of a piezoelectric ceramic body such as PZT.

The reinforcing plate 172 has a flat plate shape. The reinforcing plate 172 is located between the first surface 21a of the channel member 21 and the back surface of the piezoelectric ceramic body 171 opposite to the front surface on which the surface electrode 174 is located. The reinforcing plate 172 extends across the plurality of pressure chambers 162 and constitutes a ceiling portion of the plurality of pressure chambers 162. The plurality of piezoelectric elements 170 share one reinforcing plate 172.

The reinforcing plate 172 is made of a material harder than the piezoelectric ceramic body 171. For example, the reinforcing plate 172 is made of a metal such as stainless steel (SUS). In this case, the piezoelectric ceramic layer 171b is not necessarily provided.

The piezoelectric element 170 is not necessarily required to include the reinforcing plate 172. In this case, the piezoelectric ceramic body 171 constitutes a ceiling portion of the plurality of pressure chambers 162.

The internal electrode 173 is located inside the piezoelectric ceramic body 171. To be more specific, the internal electrode 173 is located between the two piezoelectric ceramic layers 171a and 171b. The internal electrode 173 is formed over substantially the entire surface in the planar direction in the region between the piezoelectric ceramic layer 171a and the piezoelectric ceramic layer 171b. That is, the internal electrode 173 overlaps with all the pressure chambers 162 in the region facing the piezoelectric actuator 22. The internal electrode 173 functions as a common electrode shared by the plurality of piezoelectric elements 170.

For the internal electrode 173, for example, a metal material such as an Ag-Pd based material can be used. The thickness of the internal electrode 173 is, for example, about 2 µm.

The internal electrode 173 is electrically connected to the connection electrode (not illustrated) located on the surface of the piezoelectric ceramic body 171 through a via hole formed in the piezoelectric ceramic layer 171a. The connection electrode for the internal electrode 173 is grounded and maintained at the ground potential.

The surface electrode 174 includes the electrode body 174a and an extraction electrode 174b. The electrode body 174a is located in a region facing the pressure chamber 162. The electrode body 174a is slightly smaller than the pressure chamber 162 and has a shape substantially similar to the pressure chamber 162.

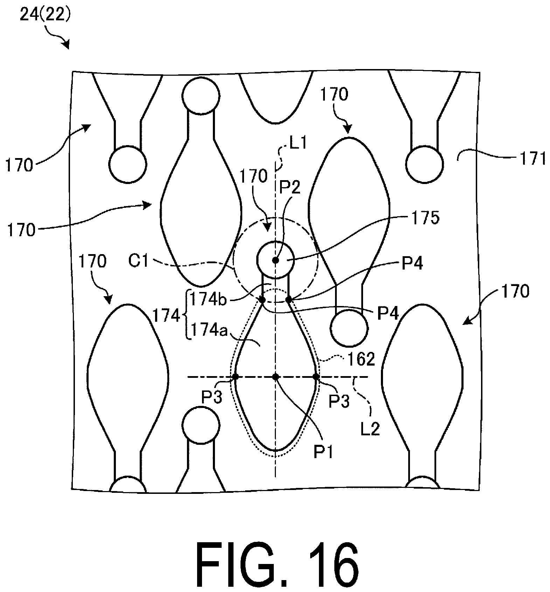

As illustrated in FIG. 5, in the embodiment, as an example, an example of a case where the pressure chamber 162 and the electrode body 174a are circular in a plan view is illustrated. However, the shapes of the pressure chamber 162 and the electrode body 174a are not limited to this example. This will be described below with reference to FIG. 16.

The extraction electrode 174b is extracted out from the electrode body 174a. The extraction electrode 174b extends linearly toward the connection electrode 175 described below. In other words, the connection electrode 175 is located at a portion of one end of the extraction electrode 174b which is extracted to the outside of the region facing the pressure chamber 162.

The electrode body 174a and the extraction electrode 174b of the surface electrode 174 may be made of, for example, an Au-based metallic material.

The connection electrode 175 has, for example, a convex shape having a thickness of about 15 µm. The connection electrode 175 is located on the surface of the piezoelectric ceramic body 171 and is connected to the surface electrode 174. To be more specific, the connection electrode 175 is located on the extraction electrode 174b, and is electrically connected to the electrode body 174a via the extraction electrode 174b. The connection electrode 175 is electrically bonded to an electrode provided on the flexible substrate 31 (see FIG. 3).

The connection electrode 175 contains a metal that is more likely to cause ion migration than the metal (for example, Au) contained in the surface electrode 174. For example, the connection electrode 175 contains Ag, Cu, Sn, Pb, or Ni. Specifically, silver-palladium containing glass frit is used as the connection electrode 175.

Each of the plurality of surface electrodes 174 is individually electrically connected to the controller 14 (see FIG. 1) via the connection electrode 175, the flexible substrate 31, and the wiring in order to individually control the potential. When an electric field is applied in the polarization direction of the piezoelectric ceramic layer 171a with the surface electrode 174 and the internal electrode 173 set at different potentials, the portion of the piezoelectric ceramic layer 171a to which the electric field is applied operates as an active portion that deforms due to the piezoelectric effect.

That is, in the piezoelectric actuator 22, the surface electrode 174, the piezoelectric ceramic layer 171a, the reinforcing plate 172, and a portion of the internal electrode 173 facing the pressure chamber 162 constitute the piezoelectric element 170. When the piezoelectric element 170 is deformed in a unimorph shape, the pressure chamber 162 is pressed and the liquid is discharged from the discharge hole 163. The discharge hole 163 is an example of a nozzle penetrating the nozzle plate 211.

### Configuration of Groove Portion

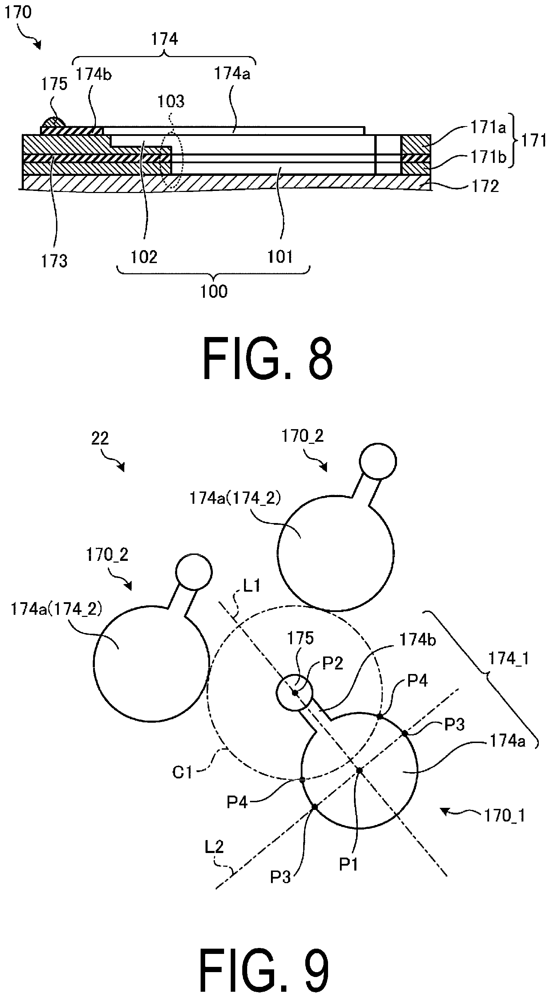

FIG. 7 is a schematic plan view of the piezoelectric element 170 according to the embodiment. FIG. 8 is a schematic cross-sectional view taken along a line VIII-VIII in FIG. 7. In FIG. 7, the size of the groove portion 100 is exaggerated for easy understanding.

As illustrated in FIG. 7, the piezoelectric element 170 has the groove portion 100. The groove portion 100 is located near the surface electrode 174 in the plan view illustrated in FIG. 7, that is, in a plan view of the piezoelectric element 170 as viewed from a direction perpendicular to the front surface of the piezoelectric ceramic body 171, and extends in a shape corresponding to the outer shape of the electrode body 174a of the surface electrode 174.

For example, in the example illustrated in FIG. 7, the groove portion 100 extends in an arc shape along the outer shape of the electrode body 174a surrounding the circular electrode body 174a. Both ends of the groove portion 100 in the longitudinal direction extend to the vicinity of the extraction electrode 174b. To be specific, one end in the longitudinal direction of the groove portion 100 is opposed to one side surface of the extraction electrode 174b, and the other end is opposed to the other side surface of the extraction electrode 174b. That is, in the example illustrated in FIG. 7, the groove portion 100 surrounds substantially the entire circumference of the electrode body 174a, to be more specific, the entire circumference of the electrode body 174a except for the region from which the extraction electrode 174b is extracted out.

Note that the groove portion 100 is not necessarily required to strictly follow the outer shape of the electrode body 174a. For example, the groove portion 100 may meander with respect to the outer shape of the electrode body 174a, or may be partially interrupted.

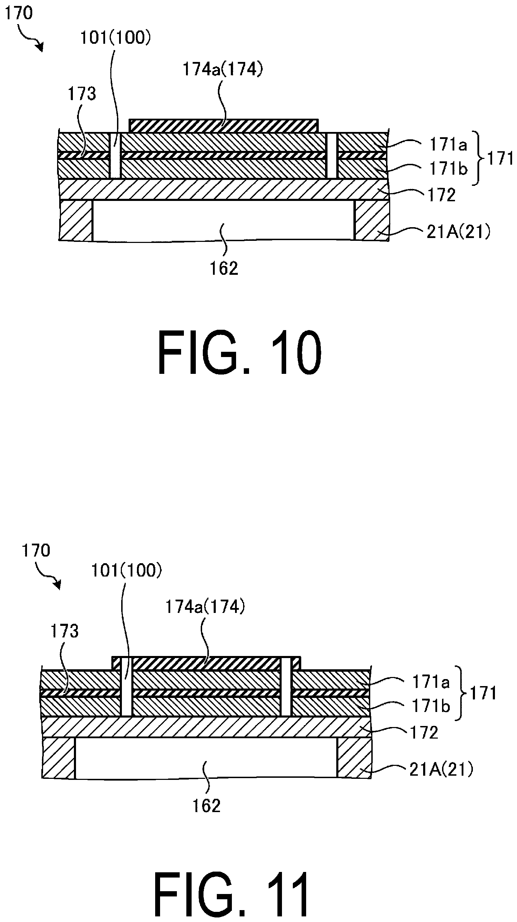

In the example illustrated in FIG. 7, the groove portion 100 is located around (outside) the electrode body 174a of each of the surface electrodes 174, but is not limited thereto, and may be located inside the electrode body 174a. This will be described below with reference to FIG. 11.

As described above, since the rigidity of the piezoelectric ceramic body 171 can be reduced by providing the groove portion 100 in the vicinity of the surface electrode 174, the driving displacement of the piezoelectric element 170 can be increased as compared with the case where the groove portion 100 is not provided.

Here, if the depth of the groove portion 100 is set to a relatively shallow depth which does not reach the internal electrode 173, the driving displacement of the piezoelectric element 170 cannot be sufficiently increased. Therefore, from the viewpoint of increasing the driving displacement of the piezoelectric element 170, it is preferable that the depth of the groove portion 100 is equal to or greater than the depth such that groove portion 100 reaches the internal electrode 173. The term "depth" means a distance in the thickness direction of the piezoelectric ceramic body 171.

On the other hand, when the depth of the groove portion 100 is equal to or greater than the depth such that the groove portion 100 reaches the internal electrode 173, the internal electrode is exposed on the wall surface of the groove portion 100. Thus, a risk exists that ion migration occurs between the connection electrode 175 and the internal electrode 173. It is known that ion migration is likely to occur in Ag, Pb, Cu, and the like. As described above, the connection electrode 175 and the internal electrode 173 include Ag. Therefore, the ion migration is likely to occur between the connection electrode 175 and the internal electrode 173. It is known that ion migration hardly occurs in Au, Fe, Pt, and the like. The surface electrode 174 contains a metal other than Ag, specifically, Au. Therefore, the ion migration is relatively unlikely to occur between the surface electrode 174 and the internal electrode 173.

The groove portion 100 includes a deep groove portion 101 and two shallow groove portions 102. One of the two shallow groove portions 102 is connected to one of both end portions of the deep groove portion 101, and the other of the two shallow groove portions 102 is connected to the other of both end portions of the deep groove portion 101. The deep groove portion 101 and the two shallow groove portions 102 form a continuous groove portion 100.

As illustrated in FIG. 8, the deep groove portion 101 has a depth equal to or greater than a depth such that the deep groove portion 101 reaches the internal electrode 173. On the other hand, the shallow groove portion 102 has a depth less than the depth such that the shallow groove portion 102 reaches the internal electrode 173. The shallow groove portion 102 is located closer to the connection electrode 175 than the deep groove portion 101.

As described above, in the piezoelectric element 170 according to the embodiment, the depth of the shallow groove portion 102 close to the connection electrode 175 in the groove portion 100 is shallower than that of the internal electrode 173. Thus, the distance between the position where the internal electrode 173 is exposed and the connection electrode 175 can be increased as compared with the case where a groove portion having a depth equal to or greater than the depth such that the groove portion reaches the internal electrode 173 is provided over the entire region in the longitudinal direction. As the distance between the position where the internal electrode 173 is exposed and the connection electrode 175 increases, the distance until the metal generated in the exposed portion of the internal electrode 173 by ion migration reaches the connection electrode 175 increases. That is, a short circuit between the internal electrode 173 and the connection electrode 175 is less likely to occur.

As described above, according to the piezoelectric actuator 22 of the embodiment, the driving displacement of the piezoelectric element 170 while suppressing the risk due to the ion migration can be increased.

As an example, the depth of the shallow groove portion 102 may be 15 µm or more and 20 µm or less, and the width of the shallow groove portion 102 may be 25 µm or more and 150 µm or less. As an example, the depth of the deep groove portion 101 may be 25 µm or more and 45 µm or less, and the width of the deep groove portion 101 may be 25 µm or more and 150 µm or less. As an example, when the depth of the shallow groove portion 102 is D1 and the depth of the deep groove portion 101 is D2, D1/D2 may be 0.33 or more and 0.80 or less. In other words, in a two travel-type piezoelectric actuator 22 having an internal electrode, it is preferable that the depth of the shallow groove portion 102 be 50% or more and less than 80% of the thickness of the upper layer (piezoelectric ceramic layer 171a) and the depth of the deep groove portion 101 be larger than the thickness of the upper layer and smaller than the total thickness (the total thickness of the piezoelectric ceramic layer 171a, the internal electrode 173, and the piezoelectric ceramic layer 171b). In the case of such a range, the driving displacement of the piezoelectric element 170 while suitably suppressing the risk due to ion migration can be suitably increased.

According to the liquid discharge head 8 including the piezoelectric actuator 22 according to the embodiment, since the driving displacement of the piezoelectric element 170 is large, liquid having higher viscosity can be discharged, and since a risk due to ion migration is unlikely to occur, reliability is high.

The groove portion 100 having the deep groove portion 101 and the shallow groove portion 102 can be formed by, for example, laser processing. Specifically, the groove portion 100 can be formed by changing the laser processing conditions between the deep groove portion 101 and the shallow groove portion 102. For example, the groove portion 100 may be formed by varying the output or pulse frequency of the laser between the deep groove portion 101 and the shallow groove portion 102. The groove portion 100 may be formed by varying the moving speed of the laser irradiation position, the laser irradiation time, or the like between the deep groove portion 101 and the shallow groove portion 102 while keeping the laser output or the pulse frequency constant.

As illustrated in FIG. 8, the deep groove portion 101 may penetrate the internal electrode 173. In the case of such a configuration, the rigidity of the piezoelectric ceramic body 171 can be further reduced as compared with the case where the deep groove portion 101 does not penetrate the internal electrode 173, and therefore, the driving displacement of the piezoelectric element 170 can be further increased. The deep groove portion 101 only needs to reach at least the internal electrode 173, and does not necessarily need to penetrate the internal electrode 173.

The deep groove portion 101 may have a depth such that the deep groove portion 101 reaches the reinforcing plate 172. As described above, the reinforcing plate 172 is made of a metal such as SUS harder than the piezoelectric ceramic body 171, and is less likely to be cut by a laser than the piezoelectric ceramic body 171. In other words, the reinforcing plate 172 is made of a material having a lower laser processing efficiency than the piezoelectric ceramic body 171 with respect to the selected laser light source. For this reason, the variation in the depth of the deep groove portion 101 among the plurality of piezoelectric elements 170 can be reduced, compared to a case where the depth of the deep groove portion 101 is set to a depth which does not reach the reinforcing plate 172. Accordingly, the variation in the driving displacement among the plurality of piezoelectric elements 170 can be reduced. Since the variation in driving displacement among the plurality of piezoelectric elements 170 is reduced, the variation in liquid discharging performance among the plurality of piezoelectric elements 170 can be reduced.

Without being limited to the example of FIG. 8, the deep groove portion 101 may have a depth equal to or greater than a depth such that the deep groove portion 101 reaches the reinforcing plate 172.

A boundary portion 103 between the deep groove portion 101 and the shallow groove portion 102 may have a stepped shape. That is, the end surface of the deep groove portion 101 in the longitudinal direction may be substantially vertically erected. In the case of such a configuration, for example, compared to a case where the shallow groove portion 102 has a slope shape, the variation in the exposure position of the internal electrode 173 among the plurality of piezoelectric elements 170 can be reduced. Thus, the risk of ion migration can be reliably reduced.

As illustrated in FIG. 7, the outer shape formed by the surface electrode 174 and the connection electrode 175 are line-symmetric in a plan view. To be more specific, the outer shape formed by the surface electrode 174 and the connection electrode 175 is line-symmetric with respect to a straight line L1 passing through the center point P1 of the electrode body 174a of each of the surface electrodes 174 and the center point P2 of each of the connection electrodes 175. The "outer shape formed by the surface electrode 174 and the connection electrode 175" means one silhouette formed by the surface electrode 174 and the connection electrode 175.

The groove portion 100 may be line-symmetric with respect to a line passing through a centroid of the surface electrode 174, i.e., the centroid of the electrode body 174a of the surface electrode 174, in a plan view.

For example, in the example illustrated in FIG. 7, it is assumed that the centroid of the electrode body 174a coincides with the center point P1 of the electrode body 174a. In this case, the groove portion 100 may be line-symmetric with respect to the straight line L1, which is the line of symmetry of the outer shape formed by the surface electrode 174 and the connection electrode 175. To be specific, the deep groove portion 101 may be line-symmetric with respect to the straight line L1, and the two shallow groove portions 102 may also be line-symmetric with respect to the straight line L1.

In the case of such a configuration, the point at which the displacement becomes maximum in the electrode body 174a can be positioned on the straight line passing through the centroid of the electrode body 174a or in the vicinity thereof. The closer to the centroid of the electrode body 174a the point at which the displacement becomes maximum in the electrode body 174a is, the more efficiently the energy generated by the displacement of the electrode body 174a can be transmitted to the pressure chamber 162. Therefore, with such a configuration, the pressure to the pressure chamber 162 can be efficiently transmitted.

### Position of Boundary Portion between Deep Groove Portion and Shallow Groove Portion

FIG is a schematic view for explaining the position of the boundary portion between the deep groove portion and the shallow groove portion. FIG. 9 illustrates three piezoelectric elements 170_1, 170_2, 170_3 adjacent to each other among the plurality of piezoelectric elements 170 included in the piezoelectric actuator 22. In FIG. 9, the groove portion 100 is omitted.

The position of the boundary portion 103 between the deep groove portion 101 and the shallow groove portion 102 in the groove portion 100 may be defined by, for example, a circle C1 and a straight line L2 illustrated in FIG. 9.

Specifically, as illustrated in FIG. 9, the surface electrode 174 included in the piezoelectric element 170_1 is referred to as a first surface electrode 174_1, and the surface electrode 174 included in the piezoelectric element 170_2 closest to the connection electrode 175 of the piezoelectric element 170_1 is referred to as a second surface electrode 174_2. Here, an example in which the two piezoelectric elements 170_2 are close to the piezoelectric element 170_1 at the same distance is illustrated, but the number of other piezoelectric elements 170_2 closest to the connection electrode 175 of the piezoelectric element 170_1 may be one.

The circle C1 is a virtual circle that is centered on the center point P2 of the connection electrode 175 included in the piezoelectric element 170_1 and is in contact with the second surface electrode 174_2 in a plan view. The boundary portion 103 between the deep groove portion 101 and the shallow groove portion 102 in the groove portion 100 included in the piezoelectric element 170_1 may be located outside the circle C1.

With such a configuration, the distance between the position where the internal electrode 173 is exposed and the connection electrode 175 can be sufficiently increased. Therefore, the risk due to ion migration between the connection electrode 175 and the internal electrode 173 can be sufficiently reduced.

Here, the circle C1 is a virtual circle in contact with the second surface electrode 174_2. However, more specifically, the circle C1 may be a virtual circle in contact with the outer edge of the groove portion 100 included in the piezoelectric element 170_2. With such a configuration, the risk of ion migration between the connection electrode 175 and the internal electrode 173 can be reliably reduced.

The straight line L2 is a straight line that passes through the center point P1 of the electrode body 174a of the first surface electrode 174_1 and is perpendicular to the straight line L1 that passes through the center point P1 of the electrode body 174a and the center point P2 of the connection electrode 175 in a plan view.

The boundary portion 103 between the deep groove portion 101 and the shallow groove portion 102 in the groove portion 100 included in the piezoelectric element 170_1 may be located closer to the connection electrode 175 than the intersection P3 between the straight line L2 and the electrode body 174a.

From the viewpoint of increasing the driving displacement of the piezoelectric element 170, it is desirable to increase the ratio of the deep groove portion 101 in the groove portion 100. By providing the deep groove portion 101 so as to occupy at least a half or more of the outer edge of the electrode body 174a of the surface electrode 174, the driving displacement due to the provision of the shallow groove portion 102 can be made difficult to reduce.

As described above, the boundary portion 103 between the deep groove portion 101 and the shallow groove portion 102 is preferably provided at a position closer to the connection electrode 175 than the intersection P3 between the straight line L2 and the electrode body 174a and farther from the connection electrode 175 than the intersection P4 between the circle C1 and the electrode body 174a.

In other words, a position of the boundary portion 103 between the deep groove portion 101 and the shallow groove portion 102 is a position at which the internal electrode 173 is exposed. The boundary portion 103 between the deep groove portion 101 and the shallow groove portion 102 can also be referred to as both end portions in the longitudinal direction of the deep groove portion 101.

### Position of Groove Portion

FIGs. 10 and 11 are schematic views illustrating an example of the position of the groove portion 100 according to the embodiment. FIGs. 10 and 11 are cross-sectional views of the piezoelectric element 170 taken along the line L2 illustrated in FIG. 9, for example.

As illustrated in FIG. 10, the groove portion 100 may be located inside the pressure chamber 162 and outside the surface electrode 174 (the electrode body 174a) in a cross-sectional view.

In the case of such a configuration, even when the position of the electrode body 174a with respect to the pressure chambers 162 is shifted among the plurality of piezoelectric elements 170, the variation in the driving displacement to occur among the plurality of piezoelectric elements 170 due to such shifts can be made can be made difficult to occur. Therefore, the variation in discharging performance among the plurality of nozzles can be reduced.

As illustrated in FIG. 11, the groove portion 100 may be located inside the pressure chamber 162 and inside the surface electrode 174 (the electrode body 174a) in a cross-sectional view.

In the case of such a configuration, when the groove portion 100 is formed, the outer peripheral portion of the electrode body 174a is cut off by the laser. Therefore, even if the position of the electrode body 174a with respect to the pressure chamber 162 is shifted among the plurality of piezoelectric elements 170, before the cutting by the laser, the shift can be reduced by the cutting by the laser. Accordingly, since the variation in the driving displacement among the plurality of piezoelectric elements 170 is unlikely to occur, the variation in the discharging performance among the plurality of nozzles can be reduced.

### First Alternative Embodiment: Shape of Groove Portion

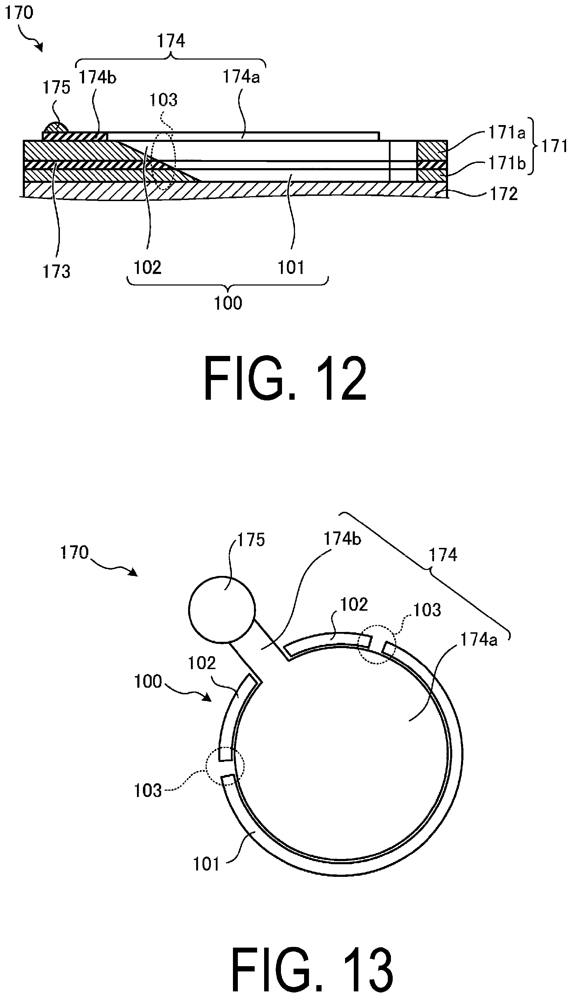

FIG. 12 is a schematic cross-sectional view of the groove portion 100 according to the first alternative embodiment. As illustrated in FIG. 12, the shallow groove portion 102 may have a slope shape that becomes progressively deeper toward the deep groove portion 101. The slope may continue to the deep groove portion 101. That is, the groove portion 100 may have a slope (inclined surface) which becomes progressively deeper from the end portion of the shallow groove portion 102 on the connection electrode 175 side toward the lowermost surface of the deep groove portion 101. In this case, a portion of the slope where the internal electrode 173 is exposed is the boundary portion 103 between the deep groove portion 101 and the shallow groove portion 102.

In this manner, by smoothly changing the depth of the groove portion 100, in a case where the piezoelectric element 170 is displaced, cracks or the like due to stress concentration can be made difficult to occur.

### Second Alternative Embodiment: Positional Relationship between Deep Groove Portion and Shallow Groove Portion

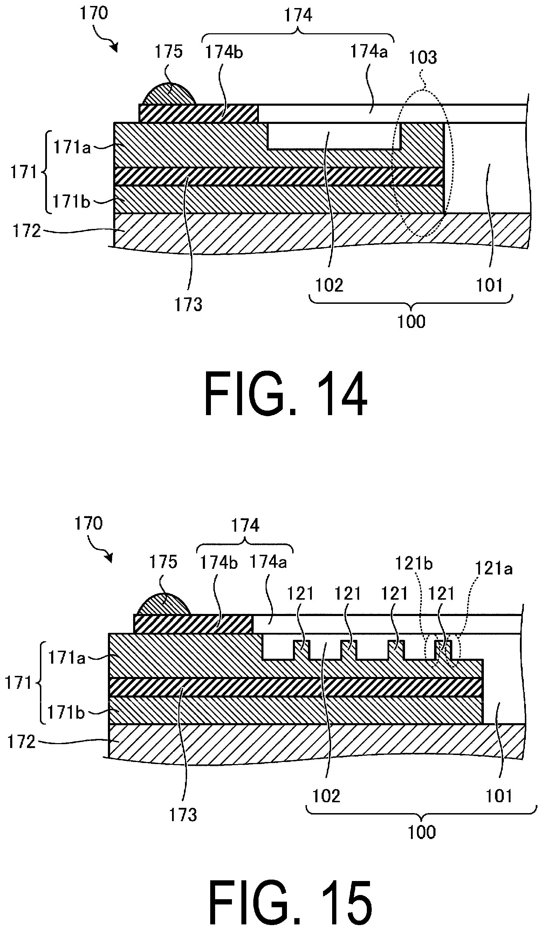

FIG. 13 is a schematic plan view illustrating the configuration of the groove portion 100 according to the second alternative embodiment. FIG. 14 is a schematic cross-sectional view illustrating the configuration of the groove portion 100 according to the second alternative embodiment.

As illustrated in FIGs. 13 and 14, the deep groove portion 101 and the shallow groove portion 102 may be spaced apart from each other. In this case, the deep groove portion 101 and the shallow groove portion 102 are spaced apart from each other by the piezoelectric ceramic body 171. In other words, the wall of the piezoelectric ceramic body 171 is located at the boundary portion 103 between the deep groove portion 101 and the shallow groove portion 102.

With such a configuration, the distance until the metal generated by ion migration at the exposure position of the internal electrode 173 reaches the connection electrode 175 can be further extended. Therefore, the risk of ion migration can be further reduced.

### Third Alternative Embodiment: Configuration of Shallow Groove Portion

FIG. 15 is a schematic cross-sectional view illustrating the configuration of the groove portion 100 according to the third alternative embodiment. As illustrated in FIG. 15, the shallow groove portion 102 may have a plurality of protruding portions 121. Each of the protruding portions 121 includes a portion 121a whose depth decreases and a portion 121b whose depth increases from the deep groove portion 101 toward the connection electrode 175.

With such a configuration, the distance until the metal generated by ion migration at the exposure position of the internal electrode 173 reaches the connection electrode 175 can be further extended. Therefore, the risk of ion migration can be further reduced.

The height of the protruding portion 121 may be, for example, at least one third or more of the depth of the shallow groove portion 102. Preferably, the height of the protruding portion 121 may be equal to or greater than half the depth of the shallow groove portion 102.

### Fourth Alternative Embodiment: Shape of Piezoelectric Element

FIG. 16 is a schematic plan view illustrating the configuration of the piezoelectric element 170 according to the fourth alternative embodiment. The shape of the piezoelectric element 170 is not limited to the shape illustrated in FIG. 5. For example, as illustrated in FIG. 16, the shape of the piezoelectric element 170 may be a bowling pin shape.

Specifically, in a plan view, the pressure chamber 162 may have a diamond shape with rounded corners. In this case, the electrode body 174a of each of the surface electrodes 174 also has a rhombic shape with rounded corners in a plan view in accordance with the shape of each of the pressure chambers 162. The extraction electrode 174b extends linearly toward the connection electrode 175 from acute-angled corner portions of the plurality of corner portions included in the electrode body 174a. The connection electrode 175 has a circular shape in a plan view.

As the same as or similar to this case as well, the piezoelectric element 170 may have the groove portion 100 (not illustrated here) that is located around or inside the electrode body 174a of the surface electrode 174 and that extends in a shape corresponding to the outer shape of the electrode body 174a. As the same as or similar to this case as well, the boundary portion 103 between the deep groove portion 101 and the shallow groove portion 102 in the groove portion 100 is preferably provided at a position closer to the connection electrode 175 than the intersection P3 between the straight line L2 and the electrode body 174a and farther from the connection electrode 175 than the intersection P4 between the circle C1 and the electrode body 174a.

As described above, the piezoelectric actuator (as an example, the piezoelectric actuator 22) according to the embodiment includes the piezoelectric element (as an example, the piezoelectric element 170) which is deformed by the application of the voltage. The piezoelectric element includes the vibrating plate (e.g., the piezoelectric ceramic layer 171b), the internal electrode (e.g., the internal electrode 173), the piezoelectric ceramic body (e.g., the piezoelectric ceramic layer 171a), the surface electrode (e.g., the surface electrode 174), the connection electrode (e.g., the connection electrode 175), and the groove portion (e.g., the groove portion 100). The internal electrode is located on a surface of the vibrating plate. The piezoelectric ceramic body is located on a surface of the internal electrode. The surface electrode is located on a surface of the piezoelectric ceramic body. The connection electrode is located on the surface of the piezoelectric ceramic body and connected to the surface electrode. In a plan view of the piezoelectric element as viewed from a direction perpendicular to the surface of the piezoelectric ceramic body, the groove portion is located around or inside the surface electrode and extends in a shape corresponding to the outer shape of the surface electrode. The groove portion includes the deep groove portion (as an example, the deep groove portion 101) and the shallow groove portion (as an example, the shallow groove portion 102). The deep groove portion has a depth equal to or greater than a depth such that the deep groove portion reaches the internal electrode. The shallow groove portion is located closer to the connection electrode than the deep groove portion and has a depth less than a depth such that the deep groove portion reaches the internal electrode.

Therefore, according to the piezoelectric actuator of the embodiment, the driving displacement of the piezoelectric element while suppressing the risk due to ion migration can be increased.

Although an embodiment of the present disclosure has been described above, the present disclosure is not limited to the embodiment described above, and various changes can be made without departing from the spirit of the present disclosure. For example, in the above-described embodiment, an example in which the channel member 21 includes the plurality of layered plates has been described, but the channel member 21 is not limited to the case of including the plurality of layered plates.

For example, the channel member 21 may be configured by forming the supply manifold 161, the individual channel 164, or the like by etching processing.

The recording device may be a vehicle body painting device. The recording device in this case may include a liquid discharge head having a nozzle surface that discharges the coating material, an arm that holds the liquid discharge head, and a controller that controls the movement of the head via the arm. The arm is, for example, an articulated robot driven by a plurality of motors.

Further effects and variations can be readily derived by those skilled in the art. Thus, a wide variety of aspects of the present invention are not limited to the specific details and representative embodiment represented and described above. Accordingly, various changes are possible without departing from the spirit or scope of the general inventive concepts defined by the appended claims and their equivalents.

### REFERENCE SIGNS

1 Printer
2 Paper feed roller
3 Guide roller
4 Applicator
5 Head case
6 Transport roller
7 Frame
8 Liquid discharge head
9 Transport roller
10 Dryer
11 Transport roller
12 Sensor portion
13 Collection roller
14 Controller
20 Head body
21 Channel member
22 Piezoelectric actuator
23 Reservoir
24 Discharge region
30 Wiring portion
31 Flexible substrate
32 Wiring board
34 Pressing member
35 Elastic member
40 Housing
45 Heat dissipation plate
100 Groove portion
101 Deep groove portion
102 Shallow groove portion
103 Boundary portion
121 Protruding portion
161 Supply manifold
162 Pressure chamber
163 Discharge hole
164 Individual channel
165 Individual supply channel
170 Piezoelectric element
171 Piezoelectric ceramic body
171a Piezoelectric ceramic layer
171b Piezoelectric ceramic layer
172 Reinforcing plate
173 Internal electrode
174 Surface electrode
174 First surface electrode
174 Second surface electrode
174a Electrode body
174b Extraction electrode
175 Connection electrode

## Claims

1. A piezoelectric actuator comprising:
a piezoelectric element that is deformed by application of a voltage, wherein
the piezoelectric element comprises
a vibrating plate,
an internal electrode located on a surface of the vibrating plate,
a piezoelectric ceramic body located on a surface of the internal electrode,
a surface electrode located on a surface of the piezoelectric ceramic body,
a connection electrode located on the surface of the piezoelectric ceramic body and connected to the surface electrode, and
a groove portion located around or inside the surface electrode and extending in a shape corresponding to an outer shape of the surface electrode in a plan view of the piezoelectric element as viewed from a direction perpendicular to the surface of the piezoelectric ceramic body, and
the groove portion comprises
a deep groove portion having a depth equal to or greater than a depth such that the deep groove portion reaches the internal electrode, and
a shallow groove portion located closer to the connection electrode than the deep groove portion and having a depth less than a depth such that the shallow groove portion reaches the internal electrode.

2. The piezoelectric actuator according to claim 1, wherein
the connection electrode contains a metal that is more likely to cause ion migration than a metal contained in the surface electrode.

3. The piezoelectric actuator according to claim 2, wherein
the connection electrode contains Ag.

4. The piezoelectric actuator according to any one of claims 1 to 3, comprising:
a plurality of the piezoelectric elements configured to share the vibrating plate, the piezoelectric ceramic body, and the internal electrode, wherein
the groove portion comprised in one of the plurality of piezoelectric elements comprises
when the surface electrode comprised in the one of the plurality of piezoelectric elements is defined as a first surface electrode and the surface electrode comprised in another piezoelectric element closest to the one of the plurality of piezoelectric elements is defined as a second surface electrode, in the plan view, a boundary portion between the deep groove portion and the shallow groove portion outside a circle in contact with the second surface electrode, the circle being centered on a center point of the connection electrode comprised in the one of the plurality of piezoelectric elements.

5. The piezoelectric actuator according to any one of claims 1 to 4, wherein
the surface electrode comprises:
an electrode body; and
an extraction portion extending from the electrode body toward the connection electrode, and
the groove portion comprises
a boundary portion between the deep groove portion and the shallow groove portion at a position closer to the connection electrode than an intersection between the electrode body and a straight line that passes through a center point of the electrode body in the plan view, the straight line being perpendicular to another straight line that passes through both the center point of the electrode body and a center point of the connection electrode.

6. The piezoelectric actuator according to any one of claims 1 to 5, wherein
the deep groove portion penetrates the internal electrode.

7. The piezoelectric actuator according to claim 6, comprising:
a reinforcing plate located on a back surface of the vibrating plate opposite to a front surface on which the internal electrode is located, the reinforcing plate being harder than the vibrating plate, wherein
the deep groove portion has a depth equal to or greater than a depth such that the deep groove portion reaches the reinforcing plate.

8. The piezoelectric actuator according to any one of claims 1 to 7, wherein
the groove portion is line-symmetric with respect to a straight line passing through a centroid of the surface electrode in the plan view.

9. The piezoelectric actuator according to any one of claims 1 to 8, wherein
a boundary portion between the deep groove portion and the shallow groove portion has a stepped shape.

10. The piezoelectric actuator according to any one of claims 1 to 8, wherein
the shallow groove portion has a slope shape that becomes progressively deeper toward the deep groove portion.

11. The piezoelectric actuator according to any one of claims 1 to 10, wherein
the deep groove portion and the shallow groove portion are spaced apart from each other.

12. The piezoelectric actuator according to any one of claims 1 to 11, wherein
the shallow groove portion comprises
a portion where a depth is shallow and a portion where the depth is deep.

13. A liquid discharge head comprising:
a nozzle configured to discharge a droplet;
a pressure chamber connected to the nozzle; and
the piezoelectric actuator according to any one of claims 1 to 12, the piezoelectric actuator being deformed by application of a voltage to deform the pressure chamber.

14. The liquid discharge head according to claim 13, wherein
the pressure chamber is provided at a position overlapping the piezoelectric element in the plan view, and
the groove portion is located inside the pressure chamber and outside the surface electrode.

15. The liquid discharge head according to claim 13, wherein
the pressure chamber is provided at a position overlapping the piezoelectric element in the plan view, and
the groove portion is located inside the pressure chamber and inside the surface electrode.

16. A recording device comprising the liquid discharge head according to any one of claims 13 to 15.
